# EUROPEAN PATENT SPECIFICATION

(11) **EP 0 446 489 B1**
(45) Date of publication and mention of the grant of the patent: **15.11.1995**
(21) Application number: 90125854.1
(22) Date of filing: 31.12.1990
(51) Int. Cl.: H01R 9/09, H03H 9/10

(54) **Electronic device and terminal to be provided therefor**
Elektronisches Gerät und Klemme dafür
Dispositif électronique et borne pour celui-ci

(30) Priority: 05.03.1990 JP 53986/90; 05.03.1990 JP 53987/90; 06.03.1990 JP 54705/90
(43) Date of publication of application: 18.09.1991
(73) Proprietor: MURATA MANUFACTURING CO., LTD., Nagaokakyo-shi, Kyoto 617 (JP)
(72) Inventor: Mura, Hideo, c/o Murata Manufacturing Co. Ltd., Nagaokakyo-shi, Kyoto 617 (JP); Nagano, Koichi, c/o Murata Manufacturing Co. Ltd., Nagaokakyo-shi, Kyoto 617 (JP); Ishiguro, Toshikazu, c/o Murata Manufacturing Co., Nagaokakyo-shi, Kyoto 617 (JP)
(74) Representative: Schoppe, Fritz, Dipl.-Ing.

(56) References cited:
- EP-A- 0 327 860
- US-A- 4 323 865
- US-A- 4 639 698
- PATENT ABSTRACTS OF JAPAN vol. 3, No. 89 (E-126) 28 July 1979, & JP-A- 54 67354 (NIPPON DENKI K.K.) 30 May 1979

## Description

The present invention relates to a method of molding a resin case for an electronic device and simultaneously fixing a terminal to the case according to the generic portion of claim 1, and further relates to a terminal to be fixed in a resin case whilst the case is molded according to the generic portion of claim 7.

In a conventional way of making an electronic device such as a ladder filter, a capacitive oscillator, etc., necessary piezoelctric elements and terminals are arranged in a resin frame to be unified, and the unit is mounted in a box-type case which is shallow. This way has such drawbacks as a resin frame is necessary and as the assembly complicated. Also since all the terminals protrude their connecting portions from a peripheral surface of the case, the elctronic device is mounted on a circuit board with the periphery surface down, which is unstable.

In another well-known way for making an electronic device, a terminal for connecting electronic elements arranged inside the device with an external appliance is inserted into a mold of a resin case so that the terminal will be fixed in the case when the resin is molded into the case. The terminal has a projection which will be a contact point with the electronic elements, and this projection makes it difficult to release the case and terminal from the mold. If a cavity is made in the mold at a place where the terminal will be placed, melting resin will flow into the cavity. If a means is attached to the mold at the inlet of the cavity in order to prevent the resin from flowing into the cavity, the projection of the terminal will be caught on the means when the case and the terminal are to be released from the mold.

US-A-4,323,865 describes a piezoelectric filter comprising a plurality of piezoelectric resonators accomodated in a case such that it is formed in a compact unit. Electrical connection to the resonators is achieved by resilient terminal members having one electroconductive protuberant contact. These resilient terminal members are connected to four lead terminals as input and output terminal members, respectively, by means by lead wires. The input and output terminal members are insert-molded within respective side walls of the case.

US-A-4,639,698 discloses an electronic ceramic filter housed in an insulating case. The terminal legs of the inputting, outputting and grounding terminal boards are reduced in length so that they protrude only slightly from the opening of the insulating case. Small holes are formed in an insulating case lid which closes the opening of the insulating case, for receiving corresponding ones of the terminal legs having a reduced length.

EP-A-0 327 860 describes as to how chip-like electronic devices may be produced with a reduced volume and having their terminals bent along the outer surface of an insulation enclosing the electronic elements of the device.

It is the object of the invention to improve a method according to the generic portion of claim 1 such that no difficulties may occur when seperating the case from the mold, and to provide a terminal suited to be used with this method.

These objects are achieved by a method according to claim 1 and by a terminal according to claim 7.

The invention provides for an electronic device housed in a case and which may be easily assembled and stably mounted to a circuit board.

According to the invention, the protrusion of the terminal is positioned to be in contact with the edge of that part of the mold enclosing the projecting contact of the terminal. Since the protrusion is equal or larger in height and larger in width than the projecting contact, the protrusion prevents the resin injected into the mold from flowing toward the projecting contact, while the projecting contact is not burried in the mold. Consequently, the case and the terminal can be released from the mold smoothly. This method makes it easy to fix a terminal in a case while the case is being molded.

Advantageous embodiments are presented in the depending claims.

One of these advantageous embodiments of the method according to the invention is characterized by producing the terminal out of a first part having a projecting contact on at least one side, and out of a second part comprising the connecting portion and having a thickness equal to or larger than the height of the projecting contact which second part is attached with one end portion thereof onto the side of the first part where the projecting contact is disposed, the attached end portion of the second part forming the protrusion.

When the method according to this advantageous embodiment is produced, the edge of the second part attached to the top of the first part is positioned to be in contact with a part of the mold enclosing the first part. In this position, when molten resin is injected into the mold, the resin is prevented from flowing toward the first part. When the case and the terminal are released from the mold after the hardening of the resin, the projecting contact on the first part is never caught on the mold, since the second part attached to the first part has a thickness equal to or lager than the thickness of the projecting contact. Such, the second part acts as a stopper for the injected resin.

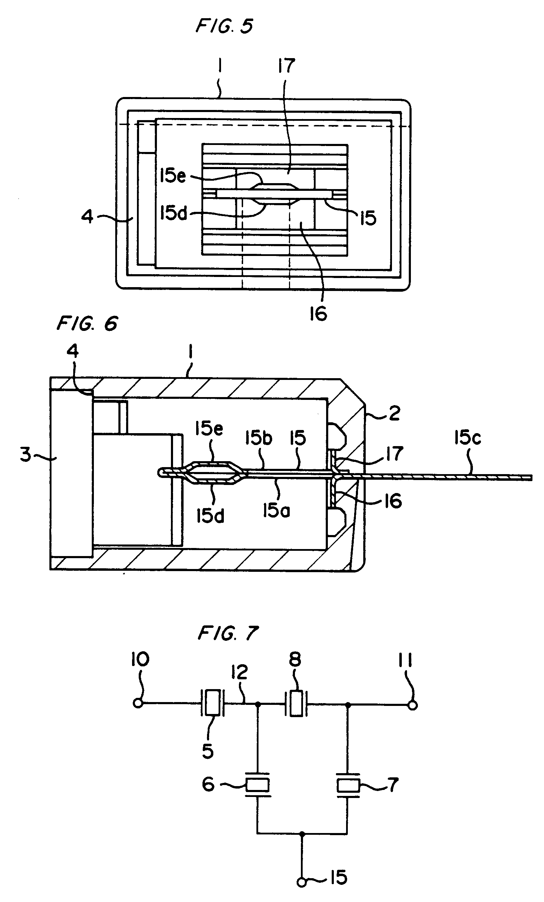

With the electronic device according to the invention the first terminal may be an earth terminal being affixed to the case such that is is substantially located in the center of the case. The second terminal may be an input terminal or an output terminal, and such a terminal is inserted into the case so that when for example the electronic device is a ladder filter the terminals and piezoelectric elements will be arranged one upon another in the case. Thus, a ladder filter having an equivalent circuit as shown in Fig. 7 is produced. According to the present invention no resin frames are required, and an electronic device as a ladder filter can easily be assembled. Further, when the connecting portions of the terminals are bent to extend along sides towards the bottom of the case, the electronic device can be mounted on a circuit board with the bottom (a large surface) down, which will increase the stability of the mounting.

Preferably, the connecting portions of the first terminal and the connecting portion of the at least one second terminal are bent along sides of the case and approximately in parallel to the bottom of the case. This arrangement enables surface mounting of the electronic device on a circuit board.

Embodiments of the invention will described in more detail in the following with reference to the accompanying drawings in which:
Fig. 1 is an exploded view of an electronic device;
Fig. 2 is a cross sectional view of the electronic device;
Fig. 3 is a plan view of an earth terminal;
Fig. 4 is a front view of the earth terminal;
Fig. 5 is a right side view of a case to which the terminal is affixed;
Fig. 6 is a sectional view of the case shown in Fig. 5 crossed in the center;
Fig. 7 is a diagram showing the equivalent circuit of the electronic device;
Fig. 8 is a cross sectional view of the case and terminals showing a modification of the terminals;
Fig. 9 is a cross sectional view of a mold of the case;
Fig. 10 is a cross sectional view of a modified mold of the case;
Fig. 11 is a cross sectional view of a mold of the case and a terminal inserted in the mold according to a second embodiment;
Fig. 12 is a development of the terminal shown in Fig. 11;
Fig. 13 is a perspective view of a terminal according to a third embodiment;
Fig. 14 is a cross sectional view of a case to which the terminal is affixed;
Fig. 15 is a cross sectional view of a mold of the case and the terminal inserted into the mold;
Fig. 16 is a cross sectional view of a modified mold of the case and the terminal inserted into the mold; and
Fig. 17 is a cross sectional view of a case to which a terminal according to a fourth embodiment is affixed.

### [Best Mode for Carrying out the Invention]

Preferred embodiments of the present invention are hereinafter described in reference to the accompanying drawings. In the embodiments, the present invention is applied to a ladder filter.

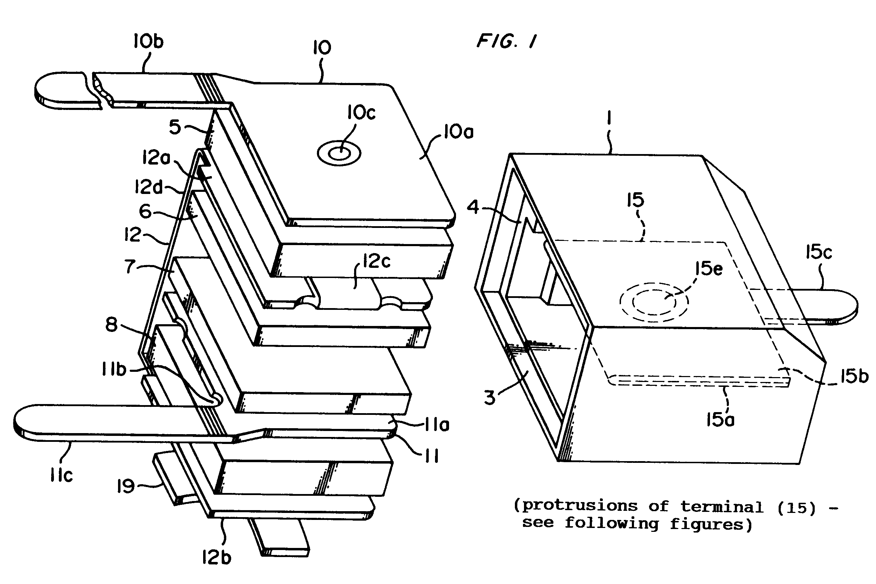

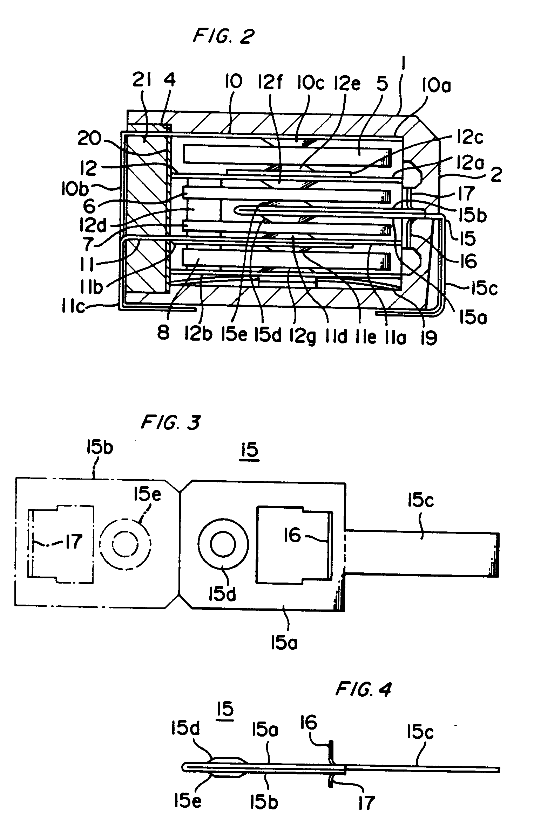

Referring to Figs. 1 and 2, the ladder filter comprises a case 1, four piezoelectric elements 5, 6, 7 and 8, an input terminal 10, an output terminal 11, a relay terminal 12, an earth terminal 15 and a spring plate 19 in the shape of a cross. The piezoelectric elements 5, 6, 7 and 8 have electrodes on the both surfaces as known.

The input terminal 10 comprises a contact plate 10a, a connecting portion 10b, and a projection 10c which is in contact with the upper surface of the piezoelectric element 5. The output terminal 11 comprises a double-folded contact plate (whose upper layer is numbered 11a and lower layer is numbered 11b in the drawings), a connecting portion 11c, and projections 11d and 11e. The projection 11d is in contact with the lower surface of the piezoelectric element 7, and the projection 11d is in contact with the upper surface of the piezoelectric element 8. The relay terminal 12 comprises a double-folded contact plate (whose upper layer is numbered 12c and lower layer is numbered 12a in the drawings), a contact plate 12b, a relay part 12d and three projections 12e, 12f and 12g. The projection 12e is in contact with the lower surface of the piezoelectric element 5, the projection 12f is in contact with the upper surface of the piezoelectric element 6, and the projection 12g is in contact with the lower surface of the piezoelectric surface 8.

The earth terminal 15 comprises a double-folded contact plate (whose upper layer is numbered 15a and lower layer is numbered 15b in the drawings), a connecting portion 15c and two projections 15d and 15e. This terminal 15 is inserted in a mold of the case 1, and when the case is molded, the terminal 15 is fixed to a wall 2 of the case 1. The projection 15d of the earth terminal 15 is in contact with the upper surface of the piezoelectric element 7, and the projection 15e is in contact with the lower surface of the piezoelectric element 6. Figs. 3 and 4 show details of the earth terminal 15. The layers 15a and 15b have cutout tabs 16 and 17 respectively. When the terminal 15 is inserted into the mold of the case 1 to be fixed in the case 1, which mold has a cavity which will make it easy to release the case 1 and the terminal 15 from the mold in spite of the projections 15d and 15e, the tabs 16 and 17 will prevent resin from flowing into the cavity toward the projections 15d and 15e.

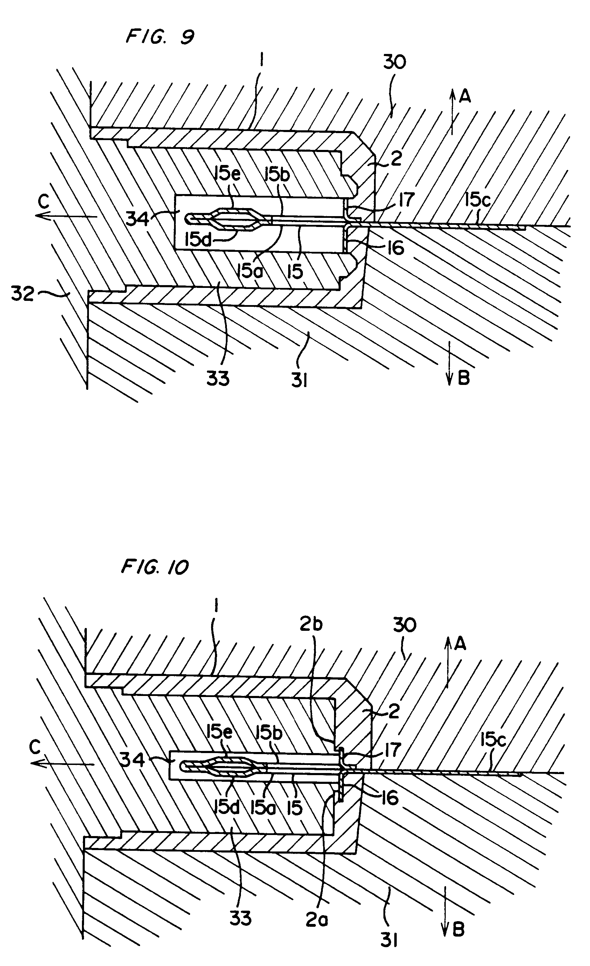

Now referring to Fig. 9, a process of molding the case 1 is described.

The mold is divided into three parts 30, 31 and 32 which will come apart in the directions A, B and C respectively. A cavity 34 into which the double-folded contact plate of the terminal 15 is to be put is formed in a core 33 of the part 32 of the mold. The height of the cavity 34 is larger than the thickness of the bulge (where the projections 15d and 15e are formed) of the terminal 15 and equal to the thickness of the portion where the tabs 16 and 17 are protruding from the both sides of the terminal 15. The width of the cavity 34 is larger than the diameter of the projections 15d and 15e and smaller than the width of the tabs 16 and 17. The tabs 16 and 17 are in contact with the wall of the cavity 34 and close the cavity 34. In this state, the tabs 16 and 17 prevent melted resin injected into the mold from flowing into the cavity 34. When the resin hardens, the case 1 is molded, and simultaneously the earth terminal 15 is fixed to the case 1.

Figs. 5 and 6 show the case 1 holding the earth terminal 15. The piezoelectric elements 5, 6, 7 and 8, the terminals 10, 11 and 12, and the spring plate 19 are inserted into the case 1 through an open side 3. Thereafter, an insulating sheet 20 is put on a step 4 of the case 1, and the open side 3 is closed by pouring resin 21 in order to shield the interior of the case 1.

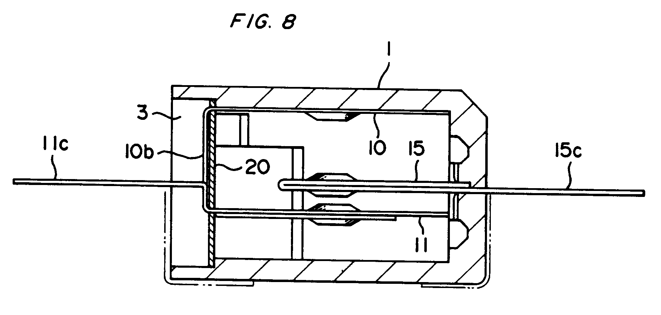

The connecting portions 10b, 11c and 15c of the respective terminals 10, 11 and 15 are bent along the sides and the bottom of the case 1 (see Fig. 2) after the resin 21 hardened. In respect to the bending operation, it is preferable that the terminals 10, 11 and 15 extend the respective connecting portions 10b, 11c and 15c on a level outside the case 1. For this reason, the terminal 10 and 11 are bent inside the case 1 as shown in Fig. 8 to extend the respective connecting portions 10b and 11c on the same level as the terminal 15. Further, it is possible to bend the connecting portions 10b, 11c and 15c outward at the bottom of the case 1 as well as to bend the connecting portions 10b, 11c and 15c inward along the bottom of the case 1.

The case 1 may be so made that the tabs 16 and 17 of the earth terminal 15 are showing on the inner surface of the case 1. However, if the tabs 16 and 17 are hidden in a step made in the wall of the case 1, the earth terminal 15 will be more insulated from the other terminals and piezoelectric elements. Specifically, as shown in Fig. 10, the cavity 34 is made thinner, and the terminal 15 is inserted in the mold so that the tabs 16 and 17 are in contact with the edge of the core 33 of the mold. Because the cavity 34 is thinner, resin injected into the mold comes over the tabs 16 and 17 as indicated by numerals 2a and 2b. Thereby, the tabs 16 and 17 prevent the melted resin from flowing into the cavity 34, and insulation of the terminal 15 from the other piezoelectric elements and the terminals will be increased.

The height of the cavity 34 is at least equal to the thickness of the bulge (where the projections 15d and 15e are formed) of the terminal 15, and the tabs 16 and 17 should have at least the same heights as the projections 15d and 15e respectively.

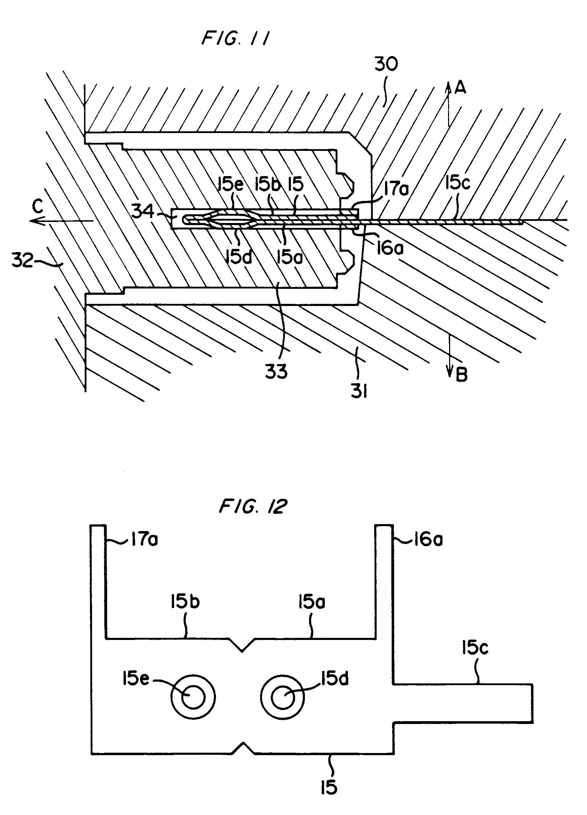

The projections 15d and 15e are both 0.05 - 0.1mm high, and the thickness of a plate which is the material of the earth terminal 15 is 0.1 - 0.15mm. The earth terminal 15 may be so constructed that the layers 15a and 15b of the contact part have extensions 16a and 17a respectively as shown in Fig. 12 and that the extensions 16a and 17b are folded back. The folded parts 16a and 17a take the place of the tabs 16 and 17 as stoppers. In this case, the mold of the case 1 is as shown in Fig. 11, and the folded parts 16a and 17a contact with the edge of the core 33 of the mold and close the cavity 34. Thus, melted resin injected into the mold cannot flow into the cavity 34.

In the process of molding the case 1, the mold is not limited to the three-part type. Also, the earth terminal 15 may have only one projection either 15d or 15e on one side of the contact part.

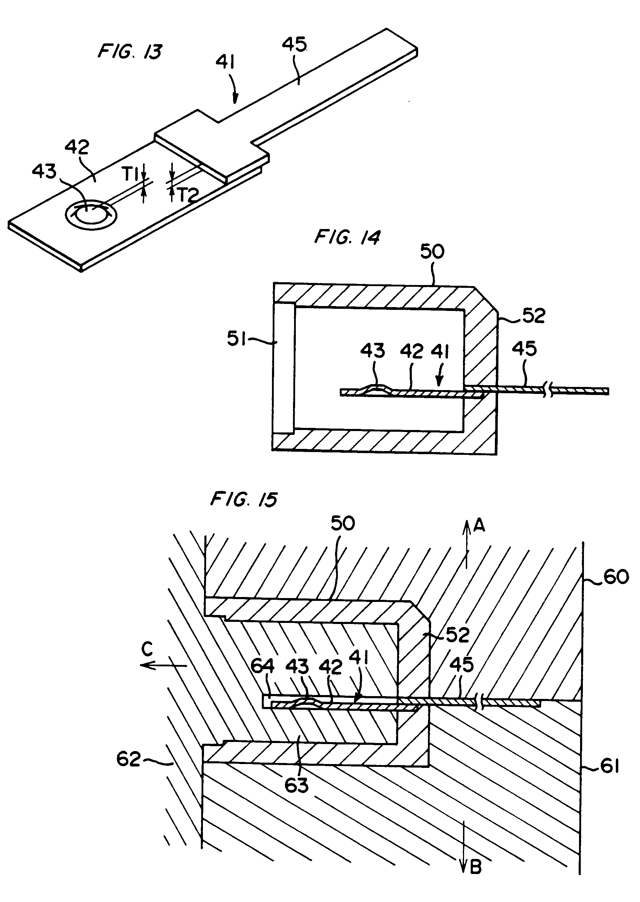

Figs. 13, 14 and 15 show another process of molding a case 50 and simultaneously fixing a terminal 41 to the case 50.

Referring to Fig. 13, the terminal 41 is composed of a first part 42 having a projection 43 and a second part 45. The first part 42 and the second part 45 overlap so that the second part 45 is put on the side of the first part 42 where the projection 43 is formed. A plate which is 0.1 0.15mm thick is cut in these parts 42 and 45, and the height of the projection 43 is 0.05 - 0.1mm. The plate to be made into the terminal 41 should have a thickness equal to or larger than the height of the projection 43.

The terminal 41 is fixed to the case 50 as shown in Fig. 14 as resin injected into the mold hardens. Piezoelectric elements and other terminals (not shown) are inserted into the case 50 through an open side 51, and the open side 51 is closed by pouring resin. Thus, an electronic device such as a ladder filter, a capacitive oscillator, etc. is produced.

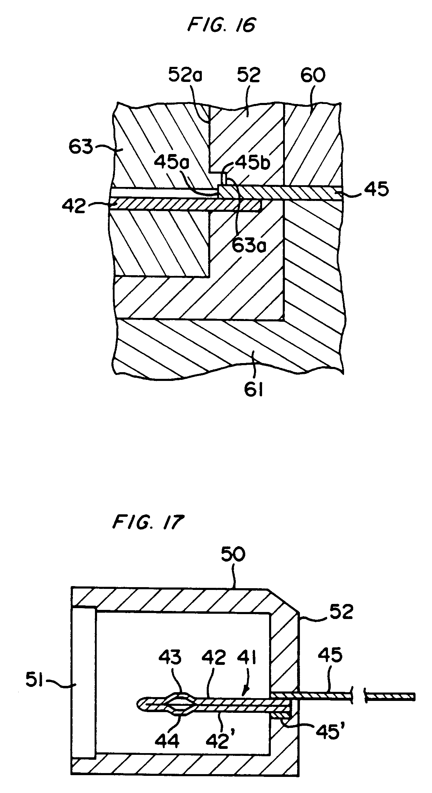

Fig. 15 shows a process of molding the case 50.

The mold is divided into three parts 60, 61 and 62 which will come apart in the directions of A, B and C respectively. In a core 63 of the mold part 62 is formed a cavity 64 into which the first part 42 of the terminal 41 is to be put. The height of the cavity 64 is equal to the thickness of the overlapping portion of the first part 42 and the second part 45 so that the first part 42 of the terminal 41 will never be stuck in the cavity 64 due to the projection 43. The width of the cavity 64 is larger than the diameter of the projection 43 and smaller than the width of the first part 42. The edge of the second part 45, which edge is on the first part 42, contacts with the edge of the core 63, that is, the cavity 64 is closed by the second part 45 of the terminal 41. Then, melted resin is injected into the mold, and the overlapping portion of the terminal 41 prevents the resin from flowing into the cavity 64. Thus, the case 50 is molded, and simultaneously the terminal 41 is fixed to the case 50.

The larger the area where the second part 45 of the terminal 41 contacts with the core 63 is, the more certainly the second part 45 prevents the resin from flowing into the cavity 64. For this reason, it is preferable that the upper end portion 45b of the second part 45 is buried in the core 63 as shown in Fig. 16.

Fixing the terminal 41 to the case 50 so to retreat the edge 45a of the second part 45 from the inner surface 52a of the case 50 as shown in Fig. 16 will decrease the possibility that the other elements to be arranged in the case 50 may contact the second part 45 of the terminal 41.

Referring to Fig. 17, the first part 42 of the terminal 41 has two projections 43 and 44 protruding from either side. More specifically, the plate is cut double as long as the part 42, and the projection 44 is formed on the extended part 42′. The extended part 42′ is folded back under the part 42. In this case, a strip of the plate 45′ stuck on the end of the part 42′ functions as a stopper of the melted resin like the second part 45 of the terminal 41.

The mold to be used in this embodiment is not limited to the three-part type.

### [Industrial Applicability]

As is evident from the above description, the electronic device according to the present invention is assembled easily without a resin frame and is mounted on a circuit board stably. Further, in the method according to the present invention, a terminal having a projecting contactor is fixed to a resin case simultaneously with molding of the resin case.

## Claims

1. A method of molding a resin case (1) for an electronic device and simultaneously fixing a terminal (15; 41) to the case (1),
said terminal (15; 41) having at least one projecting contact (15d, 15e; 43) on one side and a connecting portion (15c; 45),
comprising the steps of placing the terminal (15; 41) within a mold and injecting molten resin into the mold and seperating the case (1) from the mold after hardening of the resin,
characterized by the step of
-- providing the terminal (15; 41) with a protrusion (16, 17; 16a, 17a) between the projecting contact (15d, 15e; 43) and the connecting portion (15c; 45), the protrusion (16, 17; 16a, 17a) protruding from the side where the at least one projecting contact (15d, 15e; 43) is disposed, and having a height (T₂) equal to or larger than the heigth (T₁) of the projecting contact (15d, 15e; 43) and a width larger than the width of said projecting contact,
-- wherein the terminal (15; 41) is positioned within the mold such that the protrusion (16, 17; 16a, 17a) is in contact with an edge of that part of the mold enclosing the portion of the terminal (15; 41) comprising the projecting contact (15d, 15e; 43).

2. The method according to claim 1, characterized in
that the terminal (15; 43) is placed within the mold such that the protrusion (16, 17; 16a, 17a) is in a retreated position from an inner surface of the case (1).

3. The method according to claim 1 or 2, characterized by
forming the protrusion (16, 17) by a tab cut out of the terminal (15).

4. The method according to claim 1 or 2, characterized by
producing the terminal (15) of a plate having a thickness equal to or larger than the height of the at least one projecting contact (15d, 15e),
providing the terminal (15) with at least one extension extending sidewards, and
folding the at least one extension back in a manner overlapping the terminal (15) and forming the protrusion (16a, 17a).

5. The method according to claim 1 or 2, characterized by
producing the terminal (15; 41) of a first part (42) having a projecting contact (43) on at least one side, and of a second part (45) comprising the connecting portion and having a thickness (T₂) equal to or larger than the height (T₁) of the projecting contact (43), and
attaching the second part (45) with one end portion thereof onto the side of the first part (42) where the projecting contact (43) is disposed, the attached end portion of the second part (45) forming the protrusion.

6. The method according to claim 5, characterized by
producing the first part (42, 42′) with a further projecting contact (44) on the side opposite to the projecting contact (43), and
attaching a third part (45′) having a thickness equal to or larger than the height of the further projecting contact (44) on the side where the further projecting contact (44) is disposed, the attached third part (45′) forming a further protrusion.

7. A terminal to be fixed in a resin case (1) whilst the case (1) is molded, the terminal (15; 41) having a projecting contact (15d, 15e; 43) on at least one side and a connecting portion (15c; 45),
characterized in
that the terminal (15; 41) comprises a protrusion (16, 17; 16a, 17a) between the projecting contact (15d, 15e; 43) and the connecting portion (15c; 45), and
that the protrusion (16, 17; 16a, 17a) protrudes from the side where the at least one projecting contact (15d, 15e; 43) is disposed, and has a height (T₂) equal to or larger than the heigth (T₁) of the projecting contact (15d, 15e; 43) and a width larger than the width of said projecting contact.

8. The terminal according to claim 7, characterized in that the protrusion (16, 17) is formed by a tab cut out of the terminal (15).

9. The terminal according to claim 7, characterized in
that the terminal (15) is made of a plate having a thickness equal to or larger than the height of the at least one projecting contact (15d, 15e),
that the terminal (15) has at least one extension extending sidewards, and
that the at least one extension is folded back in a manner overlapping the terminal (15) and forming the protrusion (16a, 17a).

10. The terminal according to claim 7, characterized in
that the terminal (41) comprises:
- a first part (42) having a projecting contact (43) on at least one side, and
- a second part (45) comprising the connecting portion and having a thickness (T₂) equal to or larger than the height (T₁) of the projecting contact (43), which second part (45) is attached to one end portion thereof onto the side of the first part (42) where the projecting contact (43) is disposed, the attached end portion of the second part (45) forming the protrusion.

11. The terminal according to claim 10, characterized in
that the first part (42, 42′) comprises a further projecting contact (44) on the side opposite to the projecting contact (43), and
that a third part (45′) having a thickness equal to or larger than the height of the further projecting contact (44) is attached on the side where the further projecting contact (44) is disposed, the third part (45′) forming a further protrusion.

## Patentansprüche

1. Ein Verfahren zum Gießen eines Harzgehäuses (1) für eine elektronische Vorrichtung und zum gleichzeitigen Befestigen eines Anschlusses (15; 41) an dem Gehäuse (1),
wobei der Anschluß (15; 41) zumindest einen vorstehenden Kontakt (15d, 15e; 43) auf einer Seite und einen Verbindungsabschnitt (15c; 45) aufweist,
das die Schritte des Plazierens des Anschlusses (15; 41) in einer Gußform, des Einspritzens von geschmolzenem Harz in die Gußform, und des Trennens des Gehäuses (1) von der Gußform nach dem Aushärten des Harzes einschließt,
gekennzeichnet durch folgenden Schritt:
-- Versehen des Anschlusses (15; 41) mit einem Vorsprung (16, 17; 16a, 17a) zwischen dem vorstehenden Kontakt (15d, 15e; 43) und dem Verbindungsabschnitt (15c; 45), wobei der Vorsprung (16, 17; 16a, 17a) von der Seite vorspringt, auf der der zumindest eine vorstehende Kontakt (15d, 15e; 43) angeordnet ist, und eine Höhe (T₂), die gleich oder größer als die Höhe (T₁) des vorstehenden Kontakts (15d, 15e; 43) ist, und eine Breite, die größer als die Breite des vorstehenden Kontakts ist, aufweist,
-- wobei der Anschluß (15; 41) derart in der Gußform positioniert ist, daß der Vorsprung (16, 17; 16a, 17a) in Kontakt mit einer Kante des Teils der Gußform ist, die den Abschnitt des Anschlusses (15; 41), der den vorstehenden Kontakt (15d, 15e; 43) aufweist, umgibt.

2. Das Verfahren gemäß Anspruch 1, dadurch gekennzeichnet,
daß der Anschluß (15; 43) derart in der Gußform plaziert ist, daß sich der Vorsprung (16, 17; 16a, 17a) in einer zurückgezogenen Position von einer inneren Oberfläche des Gehäuses (1) befindet.

3. Das Verfahren gemäß Anspruch 1 oder 2, gekennzeichnet durch
das Bilden des Vorsprungs (16, 17) durch einen Streifen, der aus dem Anschluß (15) ausgeschnitten ist.

4. Das Verfahren gemäß Anspruch 1 oder 2, gekennzeichnet durch
das Erzeugen des Anschlusses (15) aus einer Platte mit einer Dicke, die gleich oder größer als die Höhe des zumindest einen vorstehenden Kontakts (15d, 15e) ist,
das Versehen des Anschlusses (15), mit zumindest einem Fortsatz, der sich seitwärts erstreckt, und
das Zurückfalten des zumindest einen Fortsatzes derart, daß er den Anschluß (15) überlappt und den Vorsprung (16a, 17a) bildet.

5. Verfahren gemäß Anspruch 1 oder 2, gekennzeichnet durch
das Erzeugen des Anschlusses (15; 41) aus einem ersten Teil (42) mit einem vorstehenden Kontakt (43) auf zumindest einer Seite und einem zweiten Teil (45), der den Verbindungsabschnitt aufweist und eine Dicke (T₂) besitzt, die gleich oder größer als die Dicke (T₁) des vorstehenden Kontakts (43) ist, und
das Anbringen des zweiten Teils (45), wobei ein Endabschnitt desselben auf der Seite des ersten Teils (42) ist, auf der der vorstehtende Kontakt (43) angeordnet ist, wobei der angebrachte Endabschnitt des zweiten Teils (45) den Vorsprung bildet.

6. Das Verfahren gemäß Anspruch 5, gekennzeichnet durch
das Erzeugen des ersten Teils (42, 42′) mit einem weiteren vorstehenden Kontakt (44) auf der Seite, die dem vorstehenden Kontakt (43) gegenüberliegt, und
das Anbringen eines dritten Teils (45′) mit einer Dicke, die gleich oder größer als die Höhe des weiteren vorstehenden Kontakts (44) ist, auf der Seite, auf der der weitere vorstehende Kontakt (44) angeordnet ist, wobei der angebrachte dritte Teil (45′) einen weiteren Vorsprung bildet.

7. Ein Anschluß, der in einem Harzgehäuse (1) befestigt werden soll, während das Gehäuse (1) gegossen wird, wobei der Anschluß (15; 41) einen vorstehenden Kontakt (15d, 15e; 43) auf zumindest einer Seite eines Verbindungsabschnitts (15c; 45) aufweist,
dadurch gekennzeichnet,
daß der Anschluß (15; 41) einen Vorsprung (16, 17; 16a, 17a) zwischen dem vorstehenden Kontakt (15d, 15e; 43) und dem Verbindungsabschnitt (15c; 45) aufweist, und
daß der Vorsprung (16, 17, 16a, 17a) von der Seite vorspringt, auf der der zumindest eine vorstehende Kontakt (15d, 15e, 43) angeordnet ist, und eine Höhe (T₂) aufweist, die gleich oder größer als die Höhe (T₁) des vorstehenden Kontakts (15d, 15e; 43) ist, und eine Breite, die größer als die Breite des vorstehenden Kontakts ist.

8. Der Anschluß gemäß Anspruch 7, dadurch gekennzeichnet,
daß der Vorsprung (16, 17) durch einen Streifen gebildet ist, der aus dem Anschluß (15) herausgeschnitten ist.

9. Der Vorsprung gemäß Anspruch 7, dadurch gekennzeichnet,
daß der Anschluß (15) aus einer Platte gebildet ist, die eine Dicke aufweist, die gleich oder größer als die Höhe des zumindest einen vorstehenden Kontakts (15d, 15e) ist,
daß der Anschluß (15) zumindest einen Fortsatz aufweist, der sich seitwärts erstreckt, und
daß der zumindest eine Fortsatz zurückgefaltet ist, derart, daß er den Anschluß (15) überlappt und den Vorsprung (16a, 17a) bildet.

10. Der Anschluß gemäß Anspruch 7, dadurch gekennzeichnet,
daß der Anschluß (41) folgende Merkmale aufweist:
- einen ersten Teil (42) mit einem vorstehenden Kontakt (43) auf zumindest einer Seite, und
- einen zweiten Teil (45), der das Verbindungsteil aufweist und eine Dicke (T₂) aufweist, die gleich oder größer als die Höhe (T₁) des vorstehenden Kontakts (43) ist, wobei der zweite Teil (45) an einem Endabschnitt desselben auf der Seite des ersten Teils (42) angebracht ist, auf der der vorstehende Kontakt (43) angeordnet ist, wobei der angebrachte Endabschnitt des zweiten Teils (45) den Vorsprung bildet.

11. Der Anschluß gemäß Anspruch 10, dadurch gekennzeichnet,
daß der erste Teil (42, 42′) einen weiteren vorstehenden Kontakt (44) auf der Seite, die dem vorstehenden Kontakt (43) gegenüberliegt, aufweist, und
daß ein dritter Teil (45′) mit einer Dicke, die gleich oder größer als die Höhe des weiteren vorstehenden Kontakts (44) ist, auf der Seite aufgebracht ist, auf der der weitere vorstehende Kontakt (44) angeordnet ist, wobei der dritte Teil (45′) einen weiteren Vorsprung bildet.

## Revendications

1. Procédé de moulage d'un boîtier en résine (1) pour un dispositif électronique et de fixation simultanée d'une borne (15; 41) au boîtier (1),
ladite borne (15; 41) présentant au moins un contact saillant (15d, 15e; 43) sur un côté et une partie de connexion (15c; 45),
comprenant les étapes consistant à placer la borne (15; 41) à l'intérieur du moule et à injecter de la résine moulue dans le moule et à démouler le boîtier (1) après durcissement de la résine,
caractérisé par les étapes consistant à
- pourvoir la borne (15; 41) d'une protubérance (16, 17; 16a, 17a) entre le contact saillant (15d, 15e; 43) et la partie de connexion (15c; 45), la protubérance (16, 17; 16a, 17a) ressortant du côté où est disposé l'au moins un contact saillant (15d, 15e; 43), et ayant une hauteur (T₂) égale ou supérieure à la hauteur (T₁) du contact saillant (15d, 15e; 43) et une largeur supérieure à la largeur dudit contact saillant,
- dans lequel la borne (15; 41) est positionnée à l'intérieur du moule de telle manière que la protubérance (16, 17; 16a, 17a) est en contact avec un bord de la pièce du moule entourant la partie de la borne (15; 41) comprenant le contact saillant (15d, 15e; 43).

2. Procédé suivant la revendication 1, caractérisé en ce que la borne (15; 43) est placée à l'intérieur du moule de telle manière que la protubérance (16, 17; 16a, 17a) se trouve en une position retirée de la surface intérieure du boîtier (1).

3. Procédé suivant la revendication 1 ou 2, caractérisé par la formation de la protubérance (16, 17) par une patte découpée dans la borne (15).

4. Procédé suivant la revendication 1 ou 2, caractérisé par le fait de
produire la borne (15) à partir d'une plaque ayant une épaisseur égale à ou supérieure à la hauteur de l'au moins un contact saillant (15d, 15e),
pourvoir la borne (15) d'au moins un prolongement s'étendant vers le côté, et
replier l'au moins un prolongement de manière à recouvrir la borne (15) et à former la protubérance (16a, 17a).

5. Procédé suivant la revendication 1 ou 2, caractérisé par le fait de
produire la borne (15; 41) à partir d'une première pièce (42) présentant un contact saillant (43) sur au moins un côté et à partir d'une seconde pièce (45) comprenant la partie de connexion et ayant une épaisseur (T₂) égale ou supérieure à la hauteur (T₁) du contact saillant (43), et
fixer la seconde pièce (45) par l'une de ses parties d'extrémité sur le côté de la première pièce (42) où est disposé le contact saillant (43), la partie d'extrémité fixée de la seconde pièce (45) formant la protubérance.

6. Procédé suivant la revendication 5, caractérisé par le fait de
produire la première pièce (42, 42′) avec un contact saillant supplémentaire (44) sur le côté opposé au contact saillant (43), et
fixer une troisième pièce (45′) ayant une épaisseur égale ou supérieure à la hauteur du contact saillant supplémentaire (44) sur le côté où est disposé le contact saillant supplémentaire (44), la troisième pièce (45′) fixée formant une protubérance supplémentaire.

7. Borne à fixer dans un boîtier en résine (1) tandis que le boîtier (1) est moulu, la borne (15; 41) présentant un contact saillant (15d, 15e; 43) sur au moins un côté et une partie de connexion (15c; 45),
caractérisée en ce
que la borne (15; 41) comprend une protubérance (16, 17; 16a, 17a) entre le contact saillant (15d, 15e; 43) et la partie de connexion (15c; 45), et
que la protubérance (16, 17; 16a, 17a) ressort du côté où est disposé l'au moins un contact saillant (15d, 15e; 43), et a une hauteur (T₂) égale ou supérieure à la hauteur (T₁) du contact saillant (15d, 15e; 43) et une largeur supérieure à la largeur dudit contact saillant.

8. Borne suivant la revendication 7, caractérisée en ce que la protubérance (16, 17) est formée par une patte découpée dans la borne (15).

9. Borne suivant la revendication 7, caractérisée en ce
que la borne (15) est réalisée à partir d'une plaque ayant une épaisseur égale ou supérieure à la hauteur de l'au moins un contact saillant (15d, 15e),
que la borne (15) présente au moins un prolongement s'étendant vers le côté, et
que l'au moins un prolongement est replié de manière à recouvrir la borne (15) et à former la protubérance (16a, 17a).

10. Borne suivant la revendication 7, caractérisée en ce que la borne (41) comprend:
- une première pièce (42) présentant un contact saillant (43) sur au moins un côté, et
une seconde pièce (45) comprenant la partie de connexion et ayant une épaisseur (T₂) égale ou supérieure à la hauteur (T₁) du contact saillant (43), seconde pièce (45) qui est fixée par l'une de ses parties d'extrémité sur le côté de la première pièce (42) où est disposé le contact saillant (43), la partie d'extrémité fixée de la seconde pièce (45) formant la protubérance.

11. Borne suivant la revendication 10, caractérisée en ce
que la première pièce (42, 42′) comprend un contact saillant supplémentaire (44) sur le côté opposé au contact saillant (43), et
qu'une troisième pièce (45′) ayant une épaisseur égale ou supérieure à la hauteur du contact saillant supplémentaire (44) est fixée sur le côté où est disposé le contact saillant supplémentaire (44), la troisième pièce (45′) formant une protubérance supplémentaire.
